(19) **Europäisches Patentamt / European Patent Office / Office européen des brevets**

(11) **EP 2 977 398 B1**

(12) **EUROPEAN PATENT SPECIFICATION**

(45) Date of publication and mention of the grant of the patent:
**18.09.2019 Bulletin 2019/38**

(51) Int Cl.:
*C08J 5/18* (2006.01)     *B29C 55/12* (2006.01)
*H01G 4/18* (2006.01)     *C08L 23/12* (2006.01)
*C23C 14/14* (2006.01)

(21) Application number: **14770169.2**

(22) Date of filing: **19.03.2014**

(86) International application number:
**PCT/JP2014/057517**

(87) International publication number:
**WO 2014/148547 (25.09.2014 Gazette 2014/39)**

(54) **BIAXIALLY ORIENTED POLYPROPYLENE FILM, METALLIZED FILM AND FILM CAPACITOR**

BIAXIAL AUSGERICHTETER POLYPROPYLENFILM, METALLISIERTER FILM UND FILMKONDENSATOR

FILM DE POLYPROPYLÈNE BI-ORIENTÉ, FILM MÉTALLISÉ ET CONDENSATEUR À FILM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.03.2013   JP 2013059847**

(43) Date of publication of application:
**27.01.2016   Bulletin 2016/04**

(73) Proprietor: **Toray Industries, Inc.**
**Tokyo 103-8666 (JP)**

(72) Inventors:
• **MONNO, Teruo**
**Tsuchiura-shi**
**Ibaraki 300-0015 (JP)**

• **ASANO, Tetsuya**
**Tsuchiura-shi**
**Ibaraki 300-0015 (JP)**

(74) Representative: **Mewburn Ellis LLP**
**City Tower**
**40 Basinghall Street**
**London EC2V 5DE (GB)**

(56) References cited:
**WO-A1-2009/060944     WO-A1-2012/002123**
**JP-A- H11 273 991     JP-A- 2006 093 689**
**JP-A- 2008 127 460     JP-A- 2009 088 492**

**Description**

Technical Field

The present invention relates to a biaxially oriented polypropylene film suitable for industrial or other applications, and more particularly to a biaxially oriented polypropylene film that retains stable and high withstand voltage characteristics even at high temperatures and is suitable as a dielectric for capacitors.

Background Art

Biaxially oriented polypropylene films, which are excellent in transparency, mechanical properties, electrical properties, and other properties, have been used in various applications such as packaging applications, tape applications, and electrical applications including cable wrappings and capacitors.

Of these, in capacitor applications, biaxially oriented polypropylene films have been preferably used particularly for high-voltage capacitors in both direct current applications and alternating current applications due to their excellent withstand voltage characteristics and low-loss characteristics.

Recently, inverters have been increasingly introduced into various electric installations, and as a result, there has been an increasing demand for a reduction in size and an increase in capacity of capacitors. In response to such a market demand, particularly a demand in automotive applications (including hybrid car applications), photovoltaic power generation applications, and wind power generation applications, a biaxially oriented polypropylene film has been essential, which has improved withstand voltage characteristics and improved heat resistance and is increasingly thinner while maintaining its productivity and processability.

Such a biaxially oriented polypropylene film, from the viewpoint of withstand voltage characteristics, heat resistance, productivity, and processability, needs to have a moderately roughened surface. Roughening is particularly important for improving the slipperiness and oil impregnating ability of the film or providing a metallized capacitor with security. The security herein refers to such a function that, in a metallized capacitor including a metallized film formed on the dielectric film as an electrode, the vapor-deposited metal is dispersed by discharge energy at the time of abnormal discharge to restore insulation properties and prevent a short circuit, thereby maintaining the function of the capacitor or preventing breakdown of the capacitor. This security is an extremely important property also from the viewpoint of safety.

As the method of roughening, methods have hitherto been proposed such as mechanical methods including embossing and sandblasting, chemical methods including chemical etching using a solvent, orientation of a sheet in which a different polymer such as polyethylene is blended, and orientation of a sheet in which β-crystals are formed (see Patent Document 1).

However, disadvantageously, the mechanical methods and the chemical methods provide a low roughness density, and the orientation of a sheet in which β-crystals are formed tends to cause a large projection. In films roughened by these methods, oil impregnation between film layers in forming a capacitor tends to be insufficient to thereby cause unimpregnated portions at some parts, which may result in a reduced capacitor life. Furthermore, the orientation of a sheet in which a different polymer such as polyethylene is blended is disadvantageous in that, although few bubbles are left in forming a capacitor, the different polymer may be inappropriate for applications of the film after being recycled, leading to poor recyclability.

Furthermore, biaxially oriented polypropylene films obtained by any of these methods, when a capacitor is used at a high temperature of 100°C or higher and under harsh conditions at a potential gradient of 250 V/$\mu$m or more, may exhibit insufficient security and have a problem with reliability. The potential gradient herein refers to a value obtained by dividing the voltage applied to the dielectric film of a capacitor by the film thickness.

As a technique focusing on roughness density and uniformity of projections, a film obtained using a high melt tension polypropylene (see, for example, Patent Document 3), and a film obtained by laminating the above-mentioned polypropylene film and a normal polypropylene film (see, for example, Patent Document 2) have been proposed. However, disadvantageously, when a high melt tension polypropylene resin is used as it is for a film for capacitors, sufficient pressure resistance and sufficient heat resistance cannot be provided because of the structure of the resin, and the dielectric breakdown voltage particularly at high temperatures significantly decreases. Furthermore, the technique in which a film obtained using a high melt tension polypropylene and a normal polypropylene film are laminated is disadvantageous in that it is difficult to provide a uniform lamination thickness required for a film for capacitors particularly in the case of a thin film with a thickness of 5 $\mu$m or less. Patent Document 4 discloses a biaxially oriented polypropylene film whose degree of surface roughness is controlled, but it is less than sufficient in controlling the degree of surface roughness of the film.

Patent Documents 4 and 5, in which the roughness of at least one film surface is defined, describe that element winding characteristics and pressure resistance can be balanced by regulating the β-crystal fraction of a cast original sheet in a certain range to form a fine rough surface. According to the production method, however, the degree of surface roughness of both surfaces of the film cannot be sufficiently controlled, and the fine rough surface of the film obtained is not sufficient to achieve the pressure resistance, heat resistance, and processability required particularly for a capacitor in automotive applications.

In Patent Documents 6 and 7 which define the thermal shrinkage of a film, because of considerably high tacticity of materials used, the productivity is low, and in addition, withstand voltage characteristics at high temperatures, that is, the capacity reduction and dimensional stability of a capacitor at high temperatures are not necessarily sufficient. For a further improved withstand voltage at high temperatures, and for higher-temperature processing conditions in manufacturing a capacitor, higher heat resistance of a capacitor and film dimensional stability have been demanded. Patent Document 8 describes a polypropylene film suitable for use as a capacitor, in which the polypropylene has a meso pentad fraction of 95 to 99 % and thickness of less than 5 $\mu$m. Additionally, a method of making the polypropylene film is provided including the steps of melt-extruding a polypropylene resin, biaxially stretching the sheet and relaxing the film by 1 to 15 %. The polypropylene films that result from this production method suffer from high values for transversal thermal shrinkage stress.

Prior Art Documents

Patent Documents

Patent Document 1: JP 2001-324607 A
Patent Document 2: JP 2001-129944 A
Patent Document 3: JP 2001-72778 A
Patent Document 4: JP 11-147962 A
Patent Document 5: JP 2007-308604 A
Patent Document 6: JP 10-119127 A
Patent Document 7: JP 08-294962 A
Patent Document 8: JP 2006-093689 A

Summary of the Invention

Problems to be Solved by the Invention

The present invention aims to provide a biaxially oriented polypropylene film which has excellent withstand voltage characteristics even in high-voltage capacitor applications, has such reliability that the change in capacitance is small even under a high voltage, and secures processability into a capacitor.

Means for Solving the Problems

To solve the problems described above, the present invention discloses the following polypropylene film.

(1) A biaxially oriented polypropylene film comprising polypropylene, wherein the polypropylene has a meso pentad fraction of 95% or more but less than 98%, and the film has a micrometric thickness of 1 to 3 $\mu$m and a transversal thermal shrinkage stress at 140°C of 0 to 1 N/mm$^2$.
The present invention further discloses the following polypropylene films as preferred aspects of the above-described film.
(2) The polypropylene film described above, wherein the polypropylene having a meso pentad fraction of 95% or more but less than 98% is a linear polypropylene.
(3) The biaxially oriented polypropylene film according to any one of the above having a longitudinal thermal shrinkage stress at 140°C of 0.5 to 2 N/mm$^2$.
(4) The biaxially oriented polypropylene film according to any one of the above, wherein the sum total of the longitudinal thermal shrinkage stress at 140°C and the transversal thermal shrinkage stress at 140°C is 0.5 to 2.5 N/mm$^2$.
(5) The biaxially oriented polypropylene film according to any one of the above, having thermal shrinkages after a treatment at 140°C for 15 minutes of 4 to 7% in the longitudinal direction and 0 to 2% in the transverse direction.
(6) The biaxially oriented polypropylene film according to any one of the above, wherein the sum of thermal shrinkages after a treatment at 120°C for 15 minutes in the longitudinal direction and the transverse direction is 2.5% or less.
(7) A metallized film comprising the biaxially oriented polypropylene film according to any one of the above, and a metal film provided on at least one surface thereof.

(8) The metallized film according to the above, wherein the metal film has a surface electrical resistance in the range of 1 to 20 $\Omega/\square$.

The present invention further discloses the following film capacitor as an application of the above-described metallized film.

(9) A film capacitor comprising the metallized film according to any one of the above.

The present invention further discloses the following method as a method of producing the biaxially oriented polypropylene film according to any one the above.

(10) A method of producing the biaxially oriented film according to any one of the above, comprising the steps of:

> melt-extruding a polypropylene resin to provide an unstretched sheet;
> biaxially stretching the unstretched sheet to provide a film; and
> relaxing the film in the width direction by 20 to 30% (relaxing step (I)).

(11) The method of producing the biaxially oriented film according to the above, wherein the relaxing step (I) comprises a plurality of relaxing steps (II), and in the steps (II), a relaxation rate at a first stage is higher than a relaxation rate at any other stage.

Effects of the Invention

The present invention provides a biaxially oriented polypropylene film which has excellent withstand voltage characteristics, undergoes only a small change in capacitance even under a high voltage, and has secure processability into a capacitor. Embodiments for Carrying Out the Invention

In the biaxially oriented polypropylene film of the present invention, the meso pentad fraction of polypropylene is 95% or more but less than 98%. The film has a micrometric thickness of 1 to 3 $\mu$m and a transversal thermal shrinkage stress at 140°C of 0 to 1 N/mm$^2$.

First, the thickness will be described. The biaxially oriented polypropylene film of the present invention preferably has a micrometric film thickness of 1 to 3 $\mu$m from the viewpoint of capacitor element size and stable film formation. The film thickness is preferably at least 1.2 $\mu$m, more preferably at least 1.5 $\mu$m, and preferably not more than 2.5 $\mu$m, more preferably not more than 2.3 $\mu$m. A film having too small a thickness may be poor in mechanical strength, dielectric breakdown strength, and heat resistance. A film having too large a thickness makes it difficult to form a film having a uniform thickness, and has a small capacitance per volume when used as a dielectric for capacitors.

The polypropylene contained in the film of the present invention has a meso pentad fraction of 95% or more but less than 98%. A meso pentad fraction of not less than 98% may extremely decrease the productivity of thin films. Furthermore, the film tends to have high crystallinity, which may reduce the in-plane orientation at amorphous regions and the withstand voltage characteristics at room temperature. A meso pentad fraction of less than 95% may reduce the heat resistance, particularly, reliability at high temperatures.

The film of the present invention has a transversal thermal shrinkage stress at 140°C of 0 to 1 N/mm$^2$, more preferably 0.1 N/mm$^2$ to 0.6 N/mm$^2$. If the transversal thermal shrinkage stress at 140°C is less than 0 N/mm$^2$, the film actually does not shrink but thermally expands, and edges may be curled during an aging treatment in manufacturing a capacitor, leading to low electrical properties. If the transversal thermal shrinkage stress at 140°C is more than 1 N/mm$^2$, edges may be curled by an aging temperature in manufacturing a capacitor, leading to defects such as low electrical properties and a deformed capacitor.

Here, the technological background of the present invention will be described. To improve the heat resistance, dimensional stability, reliability, and processability into a capacitor of a polypropylene film, it is important to control the thermal shrinkage behavior of the polypropylene film. To improve the processability into a capacitor, it is important to moderately roughen the film surface to optimize the uniformity of space between the film layers and the slipperiness between the films or between the film and a conveying roll. When the film is formed into an element, it is also necessary to reduce the local adhesion between the films and residual stress.

Hence, the present invention first employs a thermal shrinkage stress at a high temperature, which cannot be expressed as the traditional thermal shrinkage, as a controllable factor. Thus, by taking a transversal thermal shrinkage stress at 140°C as a controlled object, good workmanship of an element, shape retention after high-temperature treatment, and a withstand voltage, reliability, and dimensional stability at high temperatures can be achieved.

The biaxially oriented polypropylene film of the present invention preferably has a longitudinal thermal shrinkage stress at 140°C of at least 0.5 N/mm$^2$, more preferably at least 0.9 N/mm$^2$. This value is preferably not more than 2 N/mm$^2$, more preferably not more than 1.6 N/mm$^2$. When the longitudinal thermal shrinkage stress at 140°C is in this range, the uniformity of space between the film layers is improved by the winding up in the longitudinal direction during the formation of a capacitor, and a film suitable for capacitors, which has an improved capacitor life, improved reliability, and excellent electrical properties, can be obtained.

The sum of the longitudinal thermal shrinkage stress and the transversal thermal shrinkage stress at 140°C is preferably at least 0.5 N/mm$^2$, more preferably at least 1.0 N/mm$^2$. The sum of these stresses is preferably not more than 2.5 N/mm$^2$, more preferably not more than 2.2 N/mm$^2$. When the sum of these thermal shrinkage stresses is in this range, the uniformity of space between the film layers is improved during the formation of a capacitor, and curling of edges is prevented, leading to an improved capacitor life and improved reliability. Furthermore, the connection to an edge metallikon is improved, and a capacitor having excellent electrical properties can be obtained.

The biaxially oriented polypropylene film of the present invention preferably has a thermal shrinkage after a treatment at 140°C for 15 minutes of at least 4%, more preferably at least 4.5% in the longitudinal direction. The thermal shrinkage is preferably not more than 7%, more preferably not more than 6%. The thermal shrinkage after a treatment at 140°C for 15 minutes in the transverse direction is preferably 0 to 2%, more preferably less than 1.5%. When the thermal shrinkages after a treatment at 140°C for 15 minutes in the longitudinal direction and the transverse direction are each in these ranges, particularly, the film, when subjected to vapor deposition, adheres well to a cooling can roll and can be stably processed, providing a vapor-deposited product of good quality.

The sum total of thermal shrinkages in the longitudinal direction and the transverse direction after a treatment at 120°C for 15 minutes is preferably 2.5% or less, more preferably 2.2% or less. When the sum total of thermal shrinkages in the longitudinal direction and the transverse direction after a treatment at 120°C for 15 minutes is in this range, the uniformity of space between the film layers and the dimensional stability are improved particularly during the formation of a multilayer capacitor, leading to an improved capacitor life and an improved connection between the film and a metallic edge, and a film having excellent electrical properties can be obtained.

To improve the processability into a capacitor, the biaxially oriented polypropylene film of the present invention preferably has a moderately roughened surface. This is because the moderate rough surface keeps the uniformity of space between the film layers and optimizes the slipperiness between the films or between the film and a conveying roll. Thus, the center line average roughness (SRa) is preferably 10 nm to 40 nm. If the center line average roughness (SRa) is too high, when the films are laminated, air is likely to enter between the layers, which may lead to a deteriorated capacitor element. In addition, when a metal layer is formed on the film, the metal layer may undergo puncture and the like, leading to a reduced dielectric breakdown voltage at high temperatures, a reduced capacitor life, and reduced reliability. Furthermore, charges are likely to concentrate when a voltage is applied, causing an electrical insulation defect. On the other hand, if the SRa is too low, the slip of the film is extremely reduced, leading to poor handleability and increasing the likelihood of wrinkling. The wrinkling may increase the change in capacitance in continuous use as a capacitor. For both surfaces of the film, the center line average surface roughness (SRa) is preferably in the above range, more preferably at least 15 nm, and still more preferably at least 20 nm. This value is preferably 35 nm or less, more preferably 30 nm or less. This further improves the winding properties in the capacitor element process and the change in capacitance in use as a capacitor, and a film excellent in processability and capacitor properties can be obtained.

As described above, the film of the present invention, as defined for the thermal shrinkage stress, has high thermal dimensional stability at high temperatures, and in addition, shows such a characteristic thermal shrinkage behavior that the balance between the longitudinal and transversal thermal shrinkage stresses and the thermal shrinkage is controlled. Furthermore, a capacitor obtained from the biaxially oriented polypropylene film having such a moderate rough surface retains a moderate clearance between the film layers, and therefore, even if the capacitor suffered a dielectric breakdown, it self-heals and will not be broken down by a short circuit. As a result, the capacitor life can be sustained, and stable security can be provided.

The value of SRa described above is measured in accordance with JIS B-0601 (1982). For example, it can be measured using "Non-contact three-dimensional microfigure measuring instrument (ET-30HK)" and "Three-dimensional roughness analyzer (MODEL SPA-11)" manufactured by Kosaka Laboratory Ltd. Details of the measurement conditions will be described later.

The polypropylene resin constituting the biaxially oriented polypropylene film of the present invention preferably contains a branched polypropylene (H) in an amount of 0.05 to 10% by mass. Furthermore, the polypropylene resin constituting the film of the present invention is preferably a mixture of a linear polypropylene and the branched polypropylene (H). In this case, the branched polypropylene (H) is particularly preferably a branched polypropylene (H) having a melt tension (MS) and a melt flow rate (MFR) as measured at 230°C satisfying the relationship: $\log (MS) > -0.56 \log (MFR) + 0.74$.

It is noted that the melt tension as measured at 230°C is a melt tension measured in accordance with the determination of the melt flow rate (MFR) described in JIS-K7210 (1999). Specifically, using a melt tension tester manufactured by Toyo Seiki Seisaku-Sho, Ltd., polypropylene is heated to 230°C, and the molten polypropylene is extruded at an extrusion rate of 15 mm/min into a strand. The tension generated when the strand is taken up at a rate of 6.4 m/min is measured and used as the melt tension (expressed in cN). The melt flow rate (MFR) as measured at 230°C is a melt flow rate (expressed in g/10 min) measured in accordance with JIS-K7210 (1999) under a load of 21.18 N.

The branched polypropylene (H) described above may be any polypropylene as long as the above relationship is satisfied, and from the viewpoint of film-forming properties, the melt flow rate (MFR) is preferably in the range of 1 to 20 g/10 min, more preferably in the range of 1 to 10 g/10 min. The melt tension is preferably in the range of 1 to 30 cN, more preferably in the range of 2 to 20 cN. A low melt tension tends to result in poor uniformity of the height or the density of projections, and poor uniformity of space between the film layers of a capacitor. As the melt tension increases, the uniformity of the height and the density of projections increases, and the surface tends to be denser (the number of small projections existing in large numbers per unit area increases), leading to uniform space between the film layers.

The branched polypropylene (H) having a melt tension (MS) and a melt flow rate (MFR) as measured at 230°C satisfying the relationship: log (MS) > -0.56 log (MFR) + 0.74 can be obtained, for example, by mixing an oligomer or polymer having a branched structure with a linear polypropylene. The mixing may be carried out by mixing pellets with each other, or by mixing pellets, followed by melt-kneading. Alternatively, a method can be used, in which a long-chain branched structure is introduced into a polypropylene molecule.

In general, independent granular projections can be formed also by orientation of a sheet in which a different polymer such as polyethylene is blended. The biaxially oriented polypropylene film containing the branched polypropylene (H) having a melt tension (MS) and a melt flow rate (MFR) at 230°C satisfying the relationship: log (MS) > -0.56 log (MFR) + 0.74 has a surface with excellent uniformity, which is finer and has less large projections and more uniform projections than the surface of a biaxially oriented polypropylene film obtained by adding a different polymer such as polyethylene.

By containing the branched polypropylene (H) in an amount of 0.05 to 10% by mass in the polypropylene resin, the size of spherulites formed during the process for cooling a melt-extruded resin sheet can be easily controlled to be small, and electrical insulation defects caused during a stretching process can be reduced, whereby a polypropylene film having excellent withstand voltage characteristics can be obtained.

Furthermore, the branched polypropylene (H) has an effect like that of $\alpha$-crystal nucleating agents. However, the branched polypropylene (H), if added in an amount in a certain range, is also capable of forming a rough surface by crystal modification. This addition in a certain range, combined with the above-described reduction in the size of spherulites, allows craters described below to be formed densely with their sizes being small, whereby a biaxially oriented polypropylene film having an excellent surface roughness with highly uniform projection density and few large projections can be obtained. Furthermore, the polypropylene resin preferably contains the branched polypropylene (H) in an amount of 0.5 to 8% by mass, particularly preferably 1 to 5% by mass, whereby winding properties and withstand voltage characteristics are further improved, providing a film excellent in processability into an element and capacitor properties. By containing the branched polypropylene (H) in such an amount, the polypropylene resin constituting the film, when measured in a 2nd-Run, shows at least two melting peaks. Specifically, in addition to a first melting peak (temperature: 160 to 172°C), a shoulder peak (148 to 157°C) appears. In addition, by containing the branched polypropylene (H) in such an amount, a moderately roughened surface shape with highly uniform projections is provided, and a biaxially oriented polypropylene film that exhibits excellent processability even under ambient temperature conditions in a wide range can be produced.

The branched polypropylene (H) preferably has a structure in which there are 1 to 5 3-internally-substituted olefins per 10,000 carbon atoms. The presence of the 3-internally-substituted olefins can be determined by $^1$H-NMR spectrum from the integration ratio of a signal in the region from 5.0 to 5.2 ppm to a signal in the region from 0.5 to 2.0 ppm. Specific examples of the branched polypropylene (H) include "Profax PF-814" available from Basell and "Daploy HMS-PP" (e.g., WB130HMS, WB135HMS) available from Borealis, among which resins obtained by electron beam cross-linking, which contain gel components in a small amount, are preferably used. The feature shown when such a branched polypropylene (H) is added to a polypropylene (PP) is that the melt crystallization temperature rises to the range of 115 to 130°C while that of PP is usually around 110°C. This increases the crystallinity, and consequently, the dimensional stability of the film at high temperatures will be improved.

One preferred method for forming projections on the film surface is to use crystal modification. This method is preferably used compared to addition of a resin incompatible with polypropylene, and particles such as inorganic particles and organic particles. This is because there are less substances that degrade electrical properties, and the electrical properties such as dielectric breakdown voltage are less likely to deteriorate. Surface morphologies obtained by crystal modification will now be described.

Surface formation by crystal modification is a method, as described, for example, in a document (M. Fujiyama et. al., Journal of Applied Polymer Science 36, P. 985-1048 (1988)), in which two crystal systems of polypropylene are used to form a surface; specifically, spherulites of $\alpha$-crystal (monoclinic system, crystal density: 0.936 g/cm$^3$) system and spherulites of $\beta$-crystal (hexagonal system, crystal density: 0.922 g/cm$^3$) system are formed in advance on an unstretched sheet, and in a stretching process, the thermally unstable $\beta$-crystals are modified into $\alpha$-crystals to form irregularities on the film surface. Since each of the surface irregularities formed by this method derives from deformation of spherulites, salients of circular or oval shape are observed in line. Furthermore, according to this technique, areas in a biaxially oriented film where spherulites of $\beta$-crystal system do not exist tend to be relatively flat with no irregularities formed. The aspect ratio of circular projections (craters) varies according to the ratio of longitudinal stretching to transverse stretching in biaxial stretching. When the longitudinal/transverse ratio in stretching is 1, that is, the stretching is isotropic, the projections are substantially circular and become flat as the longitudinal/transverse ratio increases. Typically, the shape formed by sequential biaxial stretching has a major axis in the transverse direction of a film (width direction of film rolls). Depending on the way spherulites are formed, the projections may take the shape of a plurality of stacked craters of different shapes, or may take the shape of an arch or a semicircle without forming a circularly-closed circle.

One method for forming projections is to add a material having an effect as a nucleating agent to enhance the nucleation ability. This increases the number of nuclei, resulting in large numbers of small fine projections, and consequently, a surface having few relatively flat areas and uniformly formed projections is formed. The branched polypropylene (H) described above is one material having an effect as a nucleating agent. By controlling the amount of the branched polypropylene (H) and the film-forming conditions, the shape of the projections described above can be controlled, and consequently, a moderately roughened surface can be formed.

Furthermore, the biaxially oriented polypropylene film of the present invention, which has high dimensional stability at high temperatures as described above, exhibits stable shape retention when formed into a capacitor. Namely, the film undergoes little dimensional change if exposed to a high temperature, and therefore the edge curl, wrinkling, and stress strain during the formation of a capacitor are reduced, providing good withstand voltage characteristics without degrading the electrical properties. When a conventional polypropylene is used, if the ambient temperature of a capacitor is as high as 120 to 140°C, swelling of the capacitor, edge curl, or destabilization of space between film layers may typically occur. As a result, the electrical properties of the capacitor are degraded, and it may be difficult to recover, particularly, insulation properties.

In the biaxially oriented polypropylene film of the present invention, one surface is preferably corona discharge treated for metal vapor deposition, and the other surface preferably not corona discharge treated.

The linear polypropylene that can be used for the biaxially oriented polypropylene film of the present invention will now be described. The linear polypropylene is typically one used for a capacitor, and preferably contains cold xylene soluble fractions (hereinafter referred to as CXS) in an amount not more than 7% by mass. Too large an amount of CXS may result in poorly stable film formation, or may form voids in the film when a biaxially stretched film is produced, which may result in an increased reduction in dimensional stability and dielectric breakdown resistance.

The cold xylene soluble fraction (CXS) herein refers to a polypropylene component that is dissolved in xylene when polypropylene is completely dissolved in xylene and then precipitated at 20°C, and this component is presumably a component less prone to crystallization because of low tacticity, low molecular weight, or the like. If such a component is contained in a resin in large amounts, thermal dimensional stability of the film may be poor, and the dielectric breakdown voltage at high temperatures may disadvantageously decrease. Accordingly, the amount of CXS is preferably 7% by mass or less, more preferably 5% by mass or less, and particularly preferably 4% by mass or less. To obtain a linear polypropylene containing CXS in such a small amount, methods can be used such as increasing the catalytic activity for obtaining a resin when polymerization is performed, and washing the resin obtained with a solvent or the propylene monomer itself.

The meso pentad fraction of the linear polypropylene, from the viewpoint of thermal shrinkage properties at high temperatures, is preferably at least 95%, more preferably at least 95.5%. The meso pentad fraction is an indicator of tacticity of polypropylene. The value of the meso pentad fraction can be determined by nuclear magnetic resonance (NMR) spectrometry. Those which show higher values have higher crystallinity and a higher melting point, and are preferred particularly from the viewpoint of dimensional stability at high temperatures and dielectric breakdown voltage. However, too large a meso pentad fraction, which favors the dimensional stability at high temperatures, tends to extremely reduce the orientation to deteriorate the stretchability, making it difficult to form a film. Furthermore, the withstand voltage characteristics at room temperature tends to be reduced. To simultaneously achieve the dimensional stability at high temperatures and the withstand voltage characteristics at room temperature, the meso pentad fraction is most preferably 95% or more but less than 98%.

To obtain a resin having such high tacticity, methods are preferably employed, such as washing resin powder of polypropylene with an aliphatic hydrocarbon such as *n*-heptane, and appropriately selecting a catalyst or promoter for polymerization .

The linear polypropylene more preferably has a melt flow rate (MFR) in the range of 1 to 10 g/10 min (230°C, 21.18 N load), particularly preferably 2 to 5 g/10 min (230°C, 21.18 N load) from the viewpoint of film-forming properties. To adjust the melt flow rate (MFR) to be in this range, methods are employed such as controlling the average molecular weight or molecular weight distribution.

The linear polypropylene, which is composed mainly of propylene homopolymer, may contain copolymer components of any other unsaturated hydrocarbon as long as the object of the present invention is not impaired. Examples of such monomer components include ethylene, 1-butene, 1-pentene, 3-methylpentene-1, 3-methylbutene-1, 1-hexene, 4-methylpentene-1, 5-ethylhexene-1, 1-octene, 1-decene, 1-dodecene, vinylcyclohexene, styrene, allylbenzene, cyclopentene, norbornene, and 5-methyl-2-norbornene. For the amount of copolymerization or blending, from the viewpoint of dielectric breakdown resistance and dimensional stability, the amount of copolymerization is preferably less than 1 mol %, and the amount of blending is preferably less than 30% by mass.

Furthermore, various additives, for example, crystal nucleating agents, antioxidants, heat stabilizers, glidants, antistatic agents, antiblocking agents, fillers, viscosity modifiers, and stain inhibitors can be added to the biaxially oriented polypropylene film of the present invention as long as the object of the present invention is not impaired. These additives can be added into pellets of polypropylene.

Of these, the type and the amount of antioxidants are preferably selected from the viewpoint of long-term heat resistance. For example, the antioxidants are preferably phenolic ones having steric hindrance, at least one of which is preferably high-molecular-weight one with a molecular weight of 500 or more. Specific examples thereof include various ones, and it is preferable to use 1,3,5-trimethyl-2,4,6-tris(3,5-di-*t*-butyl-4-hydroxybenzyl) benzene (e.g., "Irganox" (registered trademark) 1330 available from BASF: molecular weight 775.2) or tetrakis[methylene-3(3,5-di-*t*-butyl-4-hydroxyphenyl)propionate]methane (e.g., "Irganox" (registered trademark) 1010 available from BASF: molecular weight 1177.7) in combination, for example, with 2,6-di-*t*-butyl-*p*-cresol (BHT: molecular weight 220.4). The total amount of these antioxidants is preferably in the range of 0.03 to 1.0% by mass based on the total amount of polypropylene. If the amount of the antioxidants is too small, the long-term heat resistance may be poor. If the amount of the antioxidants is too large, the antioxidants may bleed out to cause blocking at high temperatures, adversely affecting a capacitor element. The amount is more preferably 0.1 to 0.9% by mass, particularly preferably 0.2 to 0.8% by mass.

The biaxially oriented film of the present invention can contain a crystal nucleating agent. As described above, the branched polypropylene (H) per se has an effect as a crystal nucleating agent of $\alpha$-crystal or $\beta$-crystal. Other examples include other types of $\alpha$-crystal nucleating agents (e.g., dibenzylidene sorbitols, sodium benzoate) and $\beta$-crystal nucleating agents (e.g., 1,2-hydroxy potassium stearate, magnesium benzoate, amide compounds such as *N,N'*-dicyclohexyl-2,6-naphthalenedicarboxamide, and quinacridone compounds). The addition of these crystal nucleating agents, however, can make it difficult to provide crystallinity and thermal properties associated therewith, dimensional stability, and surface roughness, and can also have an adverse effect on electrical properties, such as a reduction in volume specific resistance at high temperatures. Thus, the amount is preferably less than 0.1% by mass. Needless to say, the crystal nucleating agents may not be contained as long as the object of the present invention can be achieved.

The biaxially oriented polypropylene film of the present invention preferably has a surface gloss in the range of 120 to 145%, more preferably 125 to 140%, and still more preferably 130 to 135%. A low gloss means that light scattering on the film surface is great. This means that irregularities on the film surface are dense. Too low a gloss, however, means that the projection height or the number of projections is very large; as a result, the slipperiness between the film layers increases, and the dimensional stability of a capacitor at high temperatures tends to decrease. Too high a gloss means that the projection height or the number of projections is very small, and in this case, the slipperiness between the film layers is very low, which makes it difficult to form the film into a flat capacitor element. In the case of wound capacitors, problems may arise, for example, a sufficient clearance between the film layers cannot be retained to result in extremely low security. Within the above range, the withstand voltage characteristics at high temperatures and the security can be simultaneously achieved.

The ash content of the biaxially oriented polypropylene film of the present invention is preferably 50 ppm or less (by mass, the same shall apply hereinafter), more preferably 30 ppm or less, and particularly preferably 20 ppm or less. If the ash content is too high, the film may have reduced dielectric breakdown resistance, leading to reduced dielectric breakdown strength of a capacitor. To adjust the ash content to be in this range, it is important to use a material that leaves few polymerization catalyst residues. In addition, contamination from an extrusion system during film formation should be reduced as much as possible. For example, a method can be employed in which bleeding is carried out for 1 hour or more to thoroughly wash a pathway with a polymer before actually starting film formation.

The biaxially oriented polypropylene film of the present invention can be used for any type of capacitor. Specifically, the capacitor, from the viewpoint of electrode structure, may be either a foil-wound capacitor or a metallized film capacitor, and the film is preferably used also for oil-immersed capacitors impregnated with insulating oil and dry capacitors which do not use insulating oil at all. From the viewpoint of shape, the capacitor may be of wound-type or laminated-type. In particular, in terms of the properties of the film of the present invention, the film is preferably used particularly for a metallized film capacitor.

Polypropylene films generally have a low surface wetting tension, and it is difficult to stably deposit a metal thereon. Accordingly, it is preferable to surface treat the film in advance in order to improve the adhesion of the metal. Examples of the surface treatment include corona discharge treatment, plasma treatment, glow treatment, and flame treatment. Polypropylene films generally have a surface wetting tension of about 30 mN/m, and it is preferable to increase the wetting tension to about 37 to 50 mN/m, preferably 39 to 48 mN/m by such a surface treatment. When the surface wetting tension is in this range, excellent adhesion to a metal film and good security are provided.

The biaxially oriented polypropylene film of the present invention is obtained by melt-extruding materials that can provide the above-described properties into a sheet, and biaxially stretching the sheet. The biaxially stretching method can be any of inflation simultaneous biaxial stretching, tenter simultaneous biaxial stretching, and tenter sequential biaxial stretching, among which the tenter sequential biaxial stretching is preferably employed from the viewpoint of stability during the stretching process, uniform thickness of the resulting film, and control of the surface shape of the film.

The method of producing the biaxially oriented polypropylene film of the present invention will now be described.

First, a polypropylene resin is provided. The polypropylene resin, which is preferably a mixture of a linear polypropylene and a high melt tension polypropylene (the branched polypropylene (H)), is melt-extruded, passed through a filter, extruded through a slit-shaped die at a temperature of 230 to 260°C, and solidified on a cooling drum to give an unstretched sheet. In this process, to obtain the film of the present invention, it is preferable to appropriately control the temperature of the cooling drum for the purpose of appropriately forming β-crystals. In this process, to efficiently form β-crystals, it is preferable to hold the resin for a given time at a temperature at which β-crystals are formed with maximum efficiency, and this temperature is typically 115 to 135°C. The holding time is preferably at least one second. To achieve these conditions, the process may be appropriately determined according to the resin temperature, extrusion rate, take-up speed, and the like. From the viewpoint of productivity, the diameter of the cooling drum, which greatly influences the holding time, is preferably at least 1 m. Furthermore, the temperature of the cooling drum is preferably 70°C or higher, more preferably 80°C or higher, and still more preferably 85°C or higher. This temperature is preferably not higher than 120°C, more preferably not higher than 110°C, and still more preferably not higher than 100°C. If the casting drum temperature is too high, crystallization of the film excessively proceeds, which may make it difficult to perform stretching in the following step, and may form voids in the film to reduce the dielectric breakdown resistance. The unstretched sheet extruded through the die may be brought into close contact with the casting drum by any method, such as electrostatic application, method using surface tension of water, air knife method, press roll method, and submerged casting method. In particular, the air knife method, which provides good flatness and allows control of thermal shrinkage properties on both surfaces and surface roughness, is preferred.

The temperature of air from the air knife is preferably at least 35°C, more preferably at least 40°C, and still more preferably at least 45°C. This temperature is preferably not higher than 120°C, more preferably not higher than 110°C, and still more preferably not higher than 100°C. If the temperature of air from the air knife is too high, crystallization of the film excessively proceeds, which may make it difficult to perform stretching in the following step, and may form voids in the film to reduce the dielectric breakdown resistance. If the temperature of air from the air knife is too low, crystals are formed insufficiently, and it may be difficult to achieve the desired thermal shrinkage stress and surface roughness.

The velocity of air blown from the air knife is preferably 130 to 150 m/s, and the air knife preferably has a double-duct structure to improve the uniformity in the width direction. Too low an air velocity cannot provide a sufficient adhesion to the casting drum, resulting in reduced film-forming properties, whereas too high an air velocity cannot provide a uniform adhesion to the casting drum, increasing the likelihood of undesirable effects such as film-forming properties, uneven quality, and uneven thickness. In order not to cause film vibration, it is preferable to adjust the position of the air knife so that air flows to the downstream side of film formation.

The unstretched sheet is then biaxially oriented by biaxial stretching. First, the unstretched film is preheated through rolls maintained at 120 to 150°C, and the sheet was then maintained at a temperature of 130°C to 150°C, in which case, the sheet is stretched at a stretch ratio in the longitudinal direction of 4 to 7, and then cooled to room temperature. The stretching method and the stretch ratio are not critical and appropriately selected according to the properties of a polymer used. The stretched film is then guided to a tenter, and stretched 7 to 15 times in the width direction at a temperature of 140 to 165°C. The film is then heat-set at a temperature of 140 to 165°C while being subjected to 20 to 30% relaxation in the width direction, and then cooled at 100 to 150°C. The relaxation rate is particularly preferably 22 to 28%, still more preferably 22 to 25%.

To achieve the desired thermal shrinkage stress, it is preferable to provide a relaxation of at least 20% in the width direction. To achieve this relaxation rate, it is desirable to perform a plurality of relaxing steps to greatly change the relaxation rate stepwise (the plurality of relaxing steps is hereinafter referred to as "relaxing steps (II)"). Furthermore, in the relaxing steps (II), the relaxation rate at the first stage is preferably highest. The relaxing steps (II) preferably include at least three stages.

The relaxing steps (II) are carried out in heat-setting chambers, and the overall relaxation rate (hereinafter referred to as "total relaxation rate") is defined as below using the entrance width (A) of a first heat-setting chamber and the exit width (B) of a final heat-setting chamber.

$$\text{Total relaxation rate (\%)} = \text{exit width (B) of final heat-setting chamber/entrance width (A) of first heat-setting chamber} \times 100$$

When the total relaxation rate is desired to be 20%, the relaxation rates can be set as described below. As is often the case, the sum of the relaxation rate at each stage is larger than the total relaxation rate.

First chamber: first-stage relaxation rate of 10.0%
Second chamber: second-stage relaxation rate of 8.0%
Third chamber: third-stage relaxation rate of 3.4%

Also in tenter stretching, the desired thermal shrinkage stress can be stably achieved by inclining the temperature and the ratio. The thermal shrinkage stress can be further controlled by performing relaxation also in a cooling zone.

The film is relaxed in a tenter, and after coming out of the tenter and before being wound up, the film is quenched in the room temperature for 3 seconds or more, particularly preferably 5 seconds or more, whereby the dimensional stability of the film further improves. If the quench time in the room temperature is less than 3 seconds, the film is wound up before its dimensions are fixed; consequently, the dimensions of the film change after the film is unwound, and the desired thermal shrinkage stress can hardly be achieved. The quenching in the room temperature of the film is preferably carried out by blowing air or controlling the temperature of film-conveying rolls to be the room temperature.

Before winding up the film, in order to improve the adhesion of a metal to be vapor-deposited, it is preferable to corona discharge treat the surface to be subjected to vapor deposition in air, nitrogen, carbonic acid gas, or a mixed gas thereof to control the wetting tension of the film surface.

On the surface of the biaxially oriented polypropylene film of the present invention, a metal film can be provided to form a metallized film. The method thereof is not critical, and for example, a method is preferably used in which aluminum is deposited on at least one surface of a polypropylene film to provide a metal film such as an aluminum-deposited film that will serve as an internal electrode of a film capacitor. In this method, other metal components such as nickel, copper, gold, silver, chromium, and zinc can also be deposited simultaneously with or subsequently to aluminum. Furthermore, on the deposited film, a protective layer can be provided, for example, using oil.

The thickness of the metal film is preferably in the range of 20 to 100 nm from the viewpoint of electrical properties and self-healing properties of the film capacitor. For the same reason, the metal film preferably has a surface electrical resistance in the range of 1 to 20 $\Omega/\square$. The surface electrical resistance can be controlled by the metal species used and film thickness. The method of measuring the surface electrical resistance will be described later.

In the present invention, after the metal film is formed, the metallized film may be aged at a certain temperature or heat-treated as required. For insulation or other purposes, the metallized film can also be coated on at least one surface, for example, with polyphenylene oxide.

The metallized film thus obtained can be laminated or wound up by various methods to provide a film capacitor. An example of preferred methods of manufacturing a wound-type film capacitor is described below.

Aluminum is vacuum-deposited on one surface of a polypropylene film to produce a metallized polypropylene film. In the deposition, aluminum is deposited such that stripe-like margins (undeposited areas) are formed in the longitudinal direction of the film. Next, the center of each deposited area and the center of each margin on the surface are slit with a blade, and tape-like take-up reels each having a longitudinally continuous margin at one widthwise end are formed. From the take-up reel having a margin at the widthwise left and the take-up reel having a margin at the widthwise right, two leaves of the metallized polypropylene film are drawn and laminated to each other, and the laminate is wound around a core to provide a winding. As a result, the metallized polypropylene film in which the margin is located at the widthwise left and the vapor-deposited metal extends to the right and the metallized polypropylene film in which the margin is located at the widthwise right and the vapor-deposited metal extends to the left are alternately laminated. The core is removed from the winding, and the winding is pressed. Metallikon is thermally sprayed on both widthwise ends to form external electrodes, and lead wires are welded to the metallikon to provide a wound-type film capacitor. Film capacitors find use in various applications such as railway vehicles, household electric appliances (e.g., televisions and refrigerators), automobiles (including hybrid cars and electric vehicles), wind power generation, and photovoltaic power generation. The film capacitor of the present invention can also be suitably used for these applications.

Examples

The effects of the present invention will now be further described with reference to examples.

The property values in the present invention were measured and evaluated as described below.

(1) Thermal shrinkage (%)

The rate of dimensional change after holding a sample film in a hot-air oven at 120°C for 15 minutes or at 140°C for 15 minutes under the following conditions in accordance with JIS-C-2330 (2001) 7.4.6.2 was used as a thermal shrinkage at each temperature. The measurements were made for the longitudinal direction and the transverse direction of the film.

(a) Sample: 10 mm wide × 200 mm long (the longitudinal direction is set at the direction of measurement)

(b) Oven conditions: 120°C or 140°C, load: 3 gf

(c) The measuring length is based on the pre-treatment film length (L0 = 100 mm), and the thermal shrinkage is determined by the following equation using a precise value of the pre-treatment film length and post-treatment film length (L1 (mm)).

$$\text{Thermal shrinkage (\%)} = ((L0 - L1)/L0) \times 100$$

(2) Thermal shrinkage stress at 140°C (N/mm$^2$)

Thermal shrinkage force curves in the longitudinal direction and the transversal direction of a film were determined by thermomechanical analysis (TMA) (Model TMA/SS6100 manufactured by SII NanoTechnology Inc.) under the following conditions.

(a) Sample: 4 mm wide $\times$ 20 mm long (the longitudinal direction is set at the direction of measurement)
(b) Temperature program: the temperature is increased from 30°C at a heating rate of 10°C/min

<Thermal shrinkage stress at 140°C>

A thermal shrinkage force at 140°C was read from the thermal shrinkage force curve obtained, and the thermal shrinkage stress at 140°C was calculated by the following equation.

$$\text{Thermal shrinkage stress at } 140°C \text{ (N/mm}^2) = \text{thermal shrinkage force at}$$

$$140°C \text{ (N)}/\{4 \text{ (mm)} \times WMV \text{ (mm)}\}$$

In the equation, WMV is a thickness (expressed in mm) of the film determined by the weighing method in accordance with JIS-C2330 (2001) 7.4.1.2. The measurements were made three times, and an average value was determined.

(3) Film thickness ($\mu$m)

The micrometric thickness was measured in accordance with JIS C2330 (2001) 7.4.1.1.

(4) Gloss

In accordance with JIS K7105 (1981), the gloss of a sample was measured using a digital variable gloss meter UGV-5D manufactured by Suga Test Instruments Co., Ltd. at an angle of incidence of 60° and an acceptance angle of 60°. The average value of the measurements at five points of the sample was used as the gloss.

(5) Melt flow rate (MFR)

The melt flow rate (MFR) was measured in accordance with JIS-K7210 (1999) at a measurement temperature of 230°C under a load of 21.18 N.

(6) Melt tension (MS)

The melt tension (MS) was measured using a MFR measuring apparatus described in JIS-K7210 (1999). Using a melt tension tester manufactured by Toyo Seiki Seisaku-Sho, Ltd., polypropylene was heated to 230°C, and the molten polypropylene was extruded at an extrusion rate of 15 mm/min into a strand. The tension generated when the strand was taken up at a rate of 6.5 m/min was measured and used as the melt tension.

(7) Meso pentad fraction (mmmm)

A sample was dissolved in a solvent, and the meso pentad fraction (mmmm) was determined by $^{13}$C-NMR under the following conditions (reference: High Polymer Analysis Handbook, New Edition, edited by The Japan Society for Analytical Chemistry and Koubunshi Bunseki Kenkyu Kondankai (Research Society of Polymer Analysis), 1995, pp.

609 to 611).

A. Measurement conditions

Apparatus: DRX-500 manufactured by Brukner
Nucleus: $^{13}$C nucleus (resonance frequency: 125.8 MHz)
Concentration: 10 wt%
Solvent: mixed solution of benzene/deuterated *o*-dichlorobenzene at a mass ratio of 1:3
Temperature: 130°C
Spin frequency: 12 Hz
NMR sample tube: 5-mm tube
Pulse width: 45° (4.5 μs)
Pulse repetition time: 10 sec
Data point: 64K
Number of conversions: 10,000
Mode: complete decoupling

B. Analysis conditions

Fourier transform was performed at a LB (line-broadening factor) of 1.0, and the mmmm peak was set at 21.86 ppm. Peak splitting was performed using WINFIT software (available from Bruker). In the splitting, peak area splitting was performed as described below from the peak area at the high-magnetic-field side. Furthermore, automatic fitting of associated software was performed to optimize the peak area splitting, and the total of peak fractions of mmmm and ss (spinning sideband peaks of mmmm) was used as the meso pentad fraction (mmmm). The measurements were made five times, and the average value was used as the meso pentad fraction.

Peak

        (a) mrrm
        (b), (c) rrrm (split into two peaks)
        (d) rrrr
        (e) mrmm + rmrr
        (f) mmrr
        (g) mmmr
        (h) ss (spinning sideband peaks of mmmm)
        (i) mmmm
        (j) rmmr

(8) Number of 3-internally-substituted olefins

A sample is dissolved in a solvent, and the number of 3-internally-substituted olefins is determined by $^{1}$H-NMR under the following conditions.

A. Measurement conditions

Apparatus: ECX400P Model nuclear magnetic resonance apparatus manufactured by JEOL Ltd.
Nucleus: $^{1}$H nucleus (resonance frequency: 500 MHz)
Concentration: 2% by mass
Solvent: deuterated *o*-dichlorobenzene
Temperature: 120°C
Pulse width: 45°
Pulse repetition time: 7 sec
Number of conversions: 512
Mode: non decoupling

B. Analysis conditions

On the basis of the chemical shift of *o*-dichlorobenzene (7.10 ppm), the proton ratio of 3-internally-substituted olefins is determined from the ratio of the area of peaks assigned to protons of 3-internally-substituted olefins in the region from 5.0 to 5.2 ppm to the peak at 0.5 to 2.0 ppm.

(9) Cold xylene soluble fraction (CXS)

A polypropylene film sample in an amount of 0.5 g is dissolved in 100 ml of boiling xylene, and allowed to cool, after which the solution is recrystallized in a constant-temperature water tank at 20°C for 1 hour, and then filtered. The polypropylene component dissolved in the filtrate is quantitatively determined (X (g)) by liquid chromatography. The CXS is determined by the following equation using an accurately weighed value ($X_0$ (g)) of 0.5 g of the sample.

$$\text{CXS (\% by mass)} = (X/X_0) \times 100$$

(10) Center line average roughness (SRa)

Measurements were made in accordance with JIS B-0601 (1982) using "Non-contact three-dimensional microfigure measuring instrument (ET-30HK)" and "Three-dimensional roughness analyzer (MODEL SPA-11)" manufactured by Kosaka Laboratory Ltd. The measurements were repeated 10 times in the longitudinal direction, and the average value was used as the center line average roughness (SRa).

(11) Electrical resistance of metal film

A metallized film was cut into a rectangle of 10 mm in the longitudinal direction and the full width (50 mm) in the width direction to prepare a sample, and the resistance of the metal film was measured over 30 mm in the width direction by the four-terminal method. The measured value obtained was multiplied by the measured width (10 mm) and divided by the distance between electrodes (30 mm) to calculate the electrical resistance per 10 mm $\times$ 10 mm (expressed in $\Omega/\square$).

(12) Film dielectric breakdown voltage (V/$\mu$m)

The average value was determined in accordance with B method (plate electrode method) of JIS C2330 (2001) 7.4.11.2 and divided by the micrometric film thickness ($\mu$m) (described above) of the measured sample. The resulting value was expressed in V/$\mu$m.

(13) Processability into element in manufacturing capacitor (Element winding yield)

On one surface of each of the polypropylene films obtained in Examples and Comparative Examples described below, aluminum was vacuum-deposited using a vacuum metallizer manufactured by ULVAC such that the film resistance was 8 $\Omega/\square$. The aluminum was deposited in the shape of a stripe having a margin extending in the longitudinal direction (the repetition of a deposited area 39.0 mm wide and a margin 1.0 mm wide).

Next, the center of each deposited area and the center of each margin were slit with a blade, and tape-like take-up reels with a full width of 20 mm each having a 0.5-mm margin on the left or right side were formed. Two of the reels obtained, one having a left margin and one having a right margin, were laminated such that the deposited area protruded from the margin by 0.5 mm in the width direction, and the laminate was wound up to provide a round element having an electrical capacitance of about 10 $\mu$F. For the element winding, KAW-4NHB manufactured by Kaido Mfg. Co., Ltd. was used. The element was aged in a reduced-pressure atmosphere at 140°C for 8 hours, and then the collapse of the film at element edges was observed; those which have suffered the collapse were evaluated as unsatisfactory. The number ratio of those which were evaluated as unsatisfactory to the total production was expressed as a percentage and used as an index of processability (this percentage is hereinafter referred to as "element winding yield"). The element winding yield is preferably as high as possible. The element winding yield of 95% or more was graded as "A", 80% or more but less than 95% as "B", and less than 80% as "C". For the number of productions, 50 elements were used for evaluation.

(14) Evaluation of high-temperature life (evaluation of capacitor reliability)

On each of the films obtained in Examples and Comparative Examples described below, a vapor deposition pattern of aluminum, the pattern having a film resistance of 8 Ω/□ and what is called a T-shaped margin pattern in which margins were provided in the direction perpendicular to the longitudinal direction, were formed using a vacuum metallizer manufactured by ULVAC to provide a vapor-deposited reel with a width of 50 mm.

Using the reel, a capacitor element was then wound up with an element winder (KAW-4NHB) manufactured by Kaido Mfg. Co., Ltd., and provided with metallikon, after which the element was heat-treated under reduced pressure at 140°C for 10 hours, and lead wires were attached thereto to finish the capacitor element. The electrical capacitance of the capacitor element at this time was 10 μF.

For the capacitor element thus obtained, the electrical capacitance (C0) immediately after being produced was measured, and then a voltage of 250 VDC/μm was applied in an oven at 125°C to measure the electrical capacitance (C1) after 200 hours. The change in capacitance (ΔC/C) was calculated by the following equation. The change in capacitance is preferably within ± 5%. For the number of productions, 10 elements were used for evaluation, and the average value was used.

$$\Delta C/C \ (\%) = ((C1 - C0)/C0) \times 100$$

Example 1

To 100 parts by mass of a linear polypropylene resin having a meso pentad fraction of 97.9% and a melt mass flow rate (MFR) of 2.6 g/10 min available from Prime Polymer Co., Ltd., 0.5 part by mass of a branched polypropylene resin (high melt tension polypropylene Profax PF-814, meso pentad fraction: 91.0%) available from Basell was added, and the resulting mixture was fed to an extruder at a temperature of 250°C and melt-extruded at a resin temperature of 250°C through a T-shaped slit die into a sheet. The melted sheet was allowed to cool and solidify on a casting drum 1 m in diameter maintained at 90°C at an air knife temperature of 90°C and an air velocity of 140 m/s. The holding time at 110 to 135°C was measured with a radiation thermometer to be 2.8 seconds. The sheet was then gradually preheated to 140°C, and then passed through rolls having a difference in peripheral speed while being kept at a temperature of 145°C to be stretched 4.8 times in the longitudinal direction. In this process, the stretching was carried out by adding heat at the stretching region using a radiation heater (output: 3.5 kW). The film was then guided to a tenter, stretched 10 times in the width direction at a stretching temperature of 160°C, and then relaxed in the width direction in three stages to a total relaxation rate of 23% (first stage: 12.0%, second stage: 9.0%, third stage: 3.9%). The film was heat-treated at a heat-setting temperature of 150°C and a cooling temperature of 140°C, and then quenched in the room temperature for 5 seconds to provide a biaxially oriented polypropylene film with a thickness of 3.0 μm. Furthermore, one surface was corona discharge treated in air at a treating intensity of 25W·min/m². The properties of the biaxially oriented polypropylene film thus obtained were as shown in Table 1 and Table 2. The withstand voltage and the processability into an element were both excellent.

Example 2

The film formation was carried out in the same manner as in Example 1 except that the meso pentad fraction of the linear polypropylene was 95.1% to provide a biaxially oriented polypropylene film. The properties of the biaxially oriented polypropylene film obtained are shown in Table 1 and Table 2.

Example 3

The film formation was carried out in the same manner as in Example 1 except that the film thickness was 1 μm, the tenter stretching temperature 145°C, the heat-setting temperature 142°C, and the cooling temperature 125°C to provide a biaxially oriented polypropylene film. The properties of the biaxially oriented polypropylene film obtained are shown in Table 1 and Table 2.

Example 4

The film formation was carried out in the same manner as in Example 1 except that the meso pentad fraction of the linear polypropylene was 97.4%, the film thickness 2.5 μm, and the total relaxation rate 25% (first stage: 12.5%, second stage: 9.0%, third stage: 5.8%) to provide a biaxially oriented polypropylene film. The properties of the biaxially oriented polypropylene film obtained are shown in Table 1 and Table 2.

Example 5

The film formation was carried out in the same manner as in Example 1 except that the meso pentad fraction of the linear polypropylene was 97.4%, the film thickness 2.5 $\mu$m, and the total relaxation rate 22% (first stage: 11.0%, second stage: 8.0%, third stage: 4.7%) to provide a biaxially oriented polypropylene film. The properties of the biaxially oriented polypropylene film obtained are shown in Table 1 and Table 2.

Example 6

The film formation was carried out in the same manner as in Example 1 except that the tenter stretching temperature was 165°C, the heat-setting temperature 165°C, the cooling temperature 150°C, and the total relaxation rate 28% (first stage: 14.0%, second stage: 11.0%, third stage: 5.9%) to provide a biaxially oriented polypropylene film. The properties of the biaxially oriented polypropylene film obtained are shown in Table 1 and Table 2.

Example 7

The film formation was carried out in the same manner as in Example 1 except that the meso pentad fraction of the linear polypropylene was 95.1%, the stretching temperature in a tenter 140°C, the heat-setting temperature 140°C, the cooling temperature 100°C, the total relaxation rate 20% (first stage: 10.0%, second stage: 8.0%, third stage: 3.4%), and the cooling time in the room temperature 3 seconds to provide a biaxially oriented polypropylene film. The properties of the biaxially oriented polypropylene film obtained are shown in Table 1 and Table 2.

Example 8

The film formation was carried out in the same manner as in Example 1 except that the meso pentad fraction of the linear polypropylene was 97.4% to provide a biaxially oriented polypropylene film. The properties of the biaxially oriented polypropylene film obtained are shown in Table 1 and Table 2.

Example 9

The film formation was carried out in the same manner as in Example 1 except that the film thickness was 2 $\mu$m, the stretching temperature in a tenter 140°C, the heat-setting temperature 140°C, the cooling temperature 100°C, the total relaxation rate 20% (first stage: 11.0%, second stage: 7.0%, third stage: 3.3%), and the cooling time in the room temperature 3 seconds to provide a biaxially oriented polypropylene film. The properties of the biaxially oriented polypropylene film obtained are shown in Table 1 and Table 2.

Comparative Example 1

The film formation was carried out in the same manner as in Example 1 except that the meso pentad fraction of the linear polypropylene was 98.5% to provide a biaxially oriented polypropylene film. The properties of the biaxially oriented polypropylene film obtained are shown in Table 1 and Table 2.

Comparative Example 2

The film formation was carried out in the same manner as in Example 1 except that the meso pentad fraction of the linear polypropylene was 94.5% to provide a biaxially oriented polypropylene film. The properties of the biaxially oriented polypropylene film obtained are shown in Table 1 and Table 2.

Comparative Example 3

The film formation was carried out in the same manner as in Example 1 except that the meso pentad fraction of the linear polypropylene was 97.5%, the total relaxation rate 15% (first stage: 8.0%, second stage: 5.0%, third stage: 2.7%), and the quench time in the room temperature 2.5 seconds to provide a biaxially oriented polypropylene film. The properties of the biaxially oriented polypropylene film obtained are shown in Table 1 and Table 2.

Comparative Example 4

The film formation was carried out in the same manner as in Example 1 except that the meso pentad fraction of the linear polypropylene was 98.5%, the cooling temperature 50°C, and the relaxation rate 15% (first stage: 5.0%, second stage: 5.3%, third stage: 5.6%) to provide a biaxially oriented polypropylene film. The properties of the biaxially oriented polypropylene film obtained are shown in Table 1 and Table 2.

Comparative Example 5

The film formation was carried out in the same manner as in Example 1 except that the film thickness was 5 μm, the stretching temperature 165°C, the heat-setting temperature 165°C, and the relaxation rate 28% (first stage: 9.3%, second stage: 10.3%, third stage: 11.5%) to provide a biaxially oriented polypropylene film. The properties of the biaxially oriented polypropylene film obtained are shown in Table 1 and Table 2.

Comparative Example 6

The film formation was carried out in the same manner as in Example 1 except that the film thickness was 4 μm to provide a biaxially oriented polypropylene film. The properties of the biaxially oriented polypropylene film obtained are shown in Table 1 and Table 2.

Comparative Example 7

The film formation was carried out in the same manner as in Example 1 except that the meso pentad fraction of the linear polypropylene was 94.5%, the stretching temperature 165°C, the heat-setting temperature 165°C, and the relaxation rate 25% (first stage: 13.0%, second stage: 9.0%, third stage: 5.2%) to provide a biaxially oriented polypropylene film. The properties of the biaxially oriented polypropylene film obtained are shown in Table 1 and Table 2.

Comparative Example 8

The film formation was carried out in the same manner as in Example 1 except that the meso pentad fraction of the linear polypropylene was 94.5%, the stretching temperature 140°C, the heat-setting temperature 140°C, the cooling temperature 100°C, and the film thickness 5 μm to provide a biaxially oriented polypropylene film. The properties of the biaxially oriented polypropylene film obtained are shown in Table 1 and Table 2.

Table 1

Table 1

| | Meso Pentad Fraction (%) | Film Thickness (μm) | Tenter Temperature | | | Total Relaxation Rate (%) | Quench Time in the Room Temperature (sec) |
| --- | --- | --- | --- | --- | --- | --- | --- |
| | | | Stretching Temperature (°C) | Heat-Setting Temperature (°C) | Cooling Temperature (°C) | | |
| Example 1 | 97.9 | 3 | 160 | 150 | 140 | 23 | 5 |
| Example 2 | 95.1 | 3 | 160 | 150 | 140 | 23 | 5 |
| Example 3 | 97.9 | 1 | 145 | 142 | 125 | 23 | 5 |
| Example 4 | 97.4 | 2.5 | 160 | 150 | 140 | 25 | 5 |
| Example 5 | 97.4 | 2.5 | 160 | 150 | 140 | 22 | 5 |
| Example 6 | 97.9 | 3 | 165 | 165 | 150 | 28 | 5 |
| Example 7 | 95.1 | 3 | 140 | 140 | 100 | 20 | 3 |
| Example 8 | 97.4 | 3 | 160 | 150 | 140 | 23 | 5 |
| Example 9 | 97.9 | 2 | 140 | 140 | 100 | 20 | 3 |
| Comparative Example 1 | 98.5 | 3 | 160 | 150 | 140 | 23 | 5 |
| Comparative Example 2 | 94.5 | 3 | 160 | 150 | 140 | 23 | 5 |
| Comparative Example 3 | 97.5 | 3 | 160 | 150 | 140 | 15 | 2.5 |
| Comparative Example 4 | 98.5 | 3 | 160 | 150 | 50 | 15 | 5 |
| Comparative Example 5 | 97.9 | 5 | 165 | 165 | 140 | 28 | 5 |
| Comparative Example 6 | 97.9 | 4 | 160 | 150 | 140 | 23 | 5 |
| Comparative Example 7 | 94.5 | 3 | 165 | 165 | 140 | 25 | 5 |
| Comparative Example 8 | 94.5 | 5 | 140 | 140 | 100 | 23 | 5 |

Table 2

Table 2

| | Thermal Shrinkage Stress at 140° C (N/mm$^2$) | | Thermal Shrinkage at 140° C (%) | | Total Thermal Shrinkage at 120° C (%) | Element Winding Yield (Edge Curt) | Change in Capacitance ("-" indicates decrease) | Film Dielectric Breakdown Voltage (V/$\mu$m) |
|---|---|---|---|---|---|---|---|---|
| | Transversal Direction | Longitudinal Direction | Transversal Direction | Longitudinal Direction | | | | |
| Example 1 | 0.1 | 0.9 | 0.1 | 5 | 1.9 | A | -1% | 630 |
| Example 2 | 0.6 | 1.6 | 1.2 | 6 | 2.1 | B | -4% | 578 |
| Example 3 | 0.6 | 1.4 | 0.8 | 5.5 | 2 | A | -3% | 605 |
| Example 4 | 0.1 | 1 | 0.1 | 5.2 | 2 | A | -2% | 620 |
| Example 5 | 0.3 | 1.2 | 0.5 | 6 | 2.2 | A | -3% | 623 |
| Example 6 | 0 | 0.6 | 0 | 4 | 1 | A | -2% | 635 |
| Example 7 | 0.9 | 1.9 | 1.4 | 6.8 | 2.4 | B | -4% | 585 |
| Example 8 | 0.4 | 1.2 | 0.8 | 5.5 | 2 1.8 | A | -3% | 615 580 |
| Example 9 | 1 | 1.9 | 2.2 | 6.8 | | B | -4% | |
| Comparative Example 1 | -0.1 | 0.4 | -0.1 | 3.8 | 1.6 | A | -8% | 637 |
| Comparative Example 2 | 1.8 | 2.8 | 2.8 | 7.5 | 2.9 | C | -22% | 560 |
| Comparative Example 3 | 1.4 | 2.5 | 2.3 | 7.4 | 2.8 | C | -16% | 612 |
| Comparative Example 4 | 1.3 | 2.2 | 1.9 | 7 | 2.6 | C | -10% | 636 |
| Comparative Example 5 | 1.5 | 2.3 | 2.1 | 7.2 | 2.8 | C | -15% | 615 |
| Comparative Example 6 | 0.8 | 1.6 | 1.6 | 6.5 | 2.3 | C | -8% | 590 |
| Comparative Example 7 | 0.6 | 1.6 | 1.2 | 6 | 2.2 | A | -18% | 565 |

EP 2 977 398 B1

19

(continued)

| | Thermal Shrinkage Stress at 140° C (N/mm$^2$) | | Thermal Shrinkage at 140° C (%) | | Total Thermal Shrinkage at 120° C (%) | Element Winding Yield (Edge Curt) | Change in Capacitance ("-" indicates decrease) | Film Dielectric Breakdown Voltage (V/$\mu$m) |
|---|---|---|---|---|---|---|---|---|
| | Transversal Direction | Longitudinal Direction | Transversal Direction | Longitudinal Direction | | | | |
| Comparative Example 8 | 1.1 | 1.8 | 1.8 | 6.5 | 2.4 | C | -20% | 560 |

## Claims

1. A biaxially oriented polypropylene film comprising polypropylene, wherein the polypropylene has a meso pentad fraction of 95% or more but less than 98%, and the film has a micrometric thickness of 1 to 3 $\mu$m and a transversal thermal shrinkage stress at 140°C of 0 to 1 N/mm$^2$ as measured according to the method in the description.

2. The polypropylene film according to claim 1, wherein the polypropylene having a meso pentad fraction of 95% or more but less than 98% is a linear polypropylene.

3. The biaxially oriented polypropylene film according to claim 1 or 2, having a longitudinal thermal shrinkage stress at 140°C of 0.5 to 2 N/mm$^2$ as measured according to the method in the description.

4. The biaxially oriented polypropylene film according to any one of claims 1 to 3, wherein the sum total of the longitudinal thermal shrinkage stress at 140°C and the transversal thermal shrinkage stress at 140°C is 0.5 to 2.5 N/mm$^2$ as measured according to the method in the description.

5. The biaxially oriented polypropylene film according to any one of claims 1 to 4, having thermal shrinkages after a treatment at 140°C for 15 minutes of 4 to 7% in the longitudinal direction and 0 to 2% in the transverse direction as measured according to the method in the description.

6. The biaxially oriented polypropylene film according to any one of claims 1 to 5, wherein the sum of thermal shrinkages after a treatment at 120°C for 15 minutes in the longitudinal direction and the transverse direction is 2.5% or less as measured according to the method in the description.

7. A metallized film comprising the biaxially oriented polypropylene film according to any one of claims 1 to 6, and a metal film provided on at least one surface thereof.

8. The metallized film according to claim 7, wherein the metal film has a surface electrical resistance in the range of 1 to 20 $\Omega/\square$ as measured according to the method in the description.

9. A film capacitor comprising the metallized film according to claim 7 or 8.

10. A method of producing the biaxially oriented film according to any one of claims 1 to 6, comprising the steps of:

    melt-extruding a polypropylene resin to provide an unstretched sheet;
    biaxially stretching the unstretched sheet to provide a film; and
    relaxing the film in the width direction by 20 to 30% (relaxing step (I)).

11. The method of producing the biaxially oriented film according to claim 10, wherein the relaxing step (I) comprises a plurality of relaxing steps (II), and in the steps (II), a relaxation rate at a first stage is higher than a relaxation rate at any other stage.

## Patentansprüche

1. Biaxial orientierte Polypropylenfolie, die Polypropylen umfasst, wobei das Polypropylen einen meso-Pentaden-Anteil von 95 % oder mehr, aber weniger als 98 % aufweist und die Folie eine Mikrometerdicke von 1 bis 3 $\mu$m und eine gemäß dem Verfahren in der Beschreibung bei 140 °C gemessene Wärmeschrumpfspannung in Querrichtung von 0 bis 1 N/mm$^2$ aufweist.

2. Polypropylenfolie nach Anspruch 1, wobei das Polypropylen, das einen meso-Pentaden-Anteil von 95 % oder mehr, aber weniger als 98 % aufweist, ein lineares Polypropylen ist.

3. Biaxial orientierte Polypropylenfolie nach Anspruch 1 oder 2, die eine gemäß dem Verfahren in der Beschreibung bei 140 °C gemessene Wärmeschrumpfspannung in Längsrichtung von 0,5 bis 2 N/mm$^2$ aufweist.

4. Biaxial orientierte Polypropylenfolie nach einem der Ansprüche 1 bis 3, wobei die Gesamtsumme aus der Wärmeschrumpfspannung in Längsrichtung bei 140 °C und der Wärmeschrumpfspannung in Querrichtung bei 140 °C, gemessen gemäß dem Verfahren in der Beschreibung, 0,5 bis 2,5 N/mm$^2$ beträgt.

5. Biaxial orientierte Polypropylenfolie nach einem der Ansprüche 1 bis 4, die nach einer 15-minütigen Behandlung bei 140 °C gemäß dem Verfahren in der Beschreibung gemessene Wärmeschrumpfungen in Längsrichtung von 4 bis 7 % und in Querrichtung von 0 bis 2 % aufweist.

6. Biaxial orientierte Polypropylenfolie nach einem der Ansprüche 1 bis 5, wobei die Summe der nach einer 15-minütigen Behandlung bei 120 °C gemäß dem Verfahren in der Beschreibung gemessenen Wärmeschrumpfungen in Längsrichtung und in Querrichtung 2,5 % oder weniger beträgt.

7. Metallisierte Folie, umfassend eine biaxial orientierte Polypropylenfolie nach einem der Ansprüche 1 bis 6 und einen auf zumindest einer Oberfläche davon vorgesehenen Metallfilm.

8. Metallisierte Folie nach Anspruch 7, wobei der Metallfilm einen gemäß dem Verfahren in der Beschreibung gemessenen elektrischen Oberflächenwiderstand im Bereich von 1 bis 20 Ω/□ aufweist.

9. Folienkondensator, der eine metallisierte Folie nach Anspruch 7 oder 8 umfasst.

10. Verfahren zur Herstellung einer biaxial orientierten Folie nach einem der Ansprüche 1 bis 6, umfassend die folgenden Schritte:

das Schmelzextrudieren eines Polypropylenharzes, um eine ungereckte Bahn bereitzustellen;
das biaxiale Recken der ungereckten Bahn, um eine Folie bereitzustellen; und
das Relaxieren der Folie in Breitenrichtung um 20 bis 30 % (Relaxationsschritt (I)).

11. Verfahren zur Herstellung einer biaxial orientierten Folie nach Anspruch 10, wobei der Relaxationsschritt (I) eine Vielzahl von Relaxationsschritten (II) umfasst und in den Schritten (II) die Relaxationsrate der ersten Stufe höher als ist die Relaxationsrate jeglicher anderer Stufen ist.

**Revendications**

1. Film de polypropylène à orientation biaxiale comprenant du polypropylène, dans lequel le polypropylène a une fraction méso pentade de 95 % ou plus, mais de moins de 98 %, et le film a une épaisseur micrométrique de 1 à 3 μm et une contrainte de retrait thermique transversale à 140 °C de 0 à 1 N/mm$^2$ comme mesuré selon la méthode de la description.

2. Film de polypropylène selon la revendication 1, dans lequel le polypropylène ayant une fraction méso pentade de 95 % ou plus, mais de moins de 98 % est un polypropylène linéaire.

3. Film de polypropylène à orientation biaxiale selon la revendication 1 ou 2, ayant une contrainte de retrait thermique longitudinale à 140 °C de 0,5 à 2 N/mm$^2$ comme mesuré selon la méthode de la description.

4. Film de polypropylène à orientation biaxiale selon l'une quelconque des revendications 1 à 3, dans lequel la somme totale de la contrainte de retrait thermique longitudinale à 140 °C et de la contrainte de retrait thermique transversale à 140 °C est de 0,5 à 2,5 N/mm$^2$ comme mesuré selon la méthode de la description.

5. Film de polypropylène à orientation biaxiale selon l'une quelconque des revendications 1 à 4, ayant des retraits thermiques après un traitement à 140 °C pendant 15 minutes de 4 à 7 % dans la direction longitudinale et de 0 à 2 % dans la direction transversale comme mesuré selon la méthode de la description.

6. Film de polypropylène à orientation biaxiale selon l'une quelconque des revendications 1 à 5, dans lequel la somme des retraits thermiques après un traitement à 120 °C pendant 15 minutes dans la direction longitudinale et la direction transversale est de 2,5 % ou moins comme mesuré selon la méthode de la description.

7. Film métallisé comprenant le film de polypropylène à orientation biaxiale selon l'une quelconque des revendications 1 à 6, et un film métallique fourni sur au moins une surface de celui-ci.

8. Film métallisé selon la revendication 7, dans lequel le film métallique a une résistance électrique superficielle dans la plage de 1 à 20 $\Omega/\square$ comme mesuré selon la méthode de la description.

9. Condensateur à film comprenant le film métallisé selon la revendication 7 ou 8.

10. Procédé de production du film à orientation biaxiale selon l'une quelconque des revendications 1 à 6, comprenant les étapes consistant à :

> extruder à l'état fondu une résine de polypropylène pour fournir une feuille non étirée ;
> étirer biaxialement la feuille non étirée pour fournir un film ; et
> relâcher le film dans le sens de la longueur de 20 à 30 % (étape de relâchement (I)).

11. Procédé de production du film à orientation biaxiale selon la revendication 10, dans lequel l'étape de relâchement (I) comprend une pluralité d'étapes de relâchement (II), et dans les étapes (II), un taux de relaxation à un premier stade est supérieur à un taux de relaxation à n'importe quel autre stade.

**Patent documents cited in the description**

- JP 2001324607 A
- JP 2001129944 A
- JP 2001072778 A
- JP 11147962 A
- JP 2007308604 A
- JP 10119127 A
- JP 8294962 A
- JP 2006093689 A

**Non-patent literature cited in the description**

- **M. FUJIYAMA.** *Journal of Applied Polymer Science,* 1988, vol. 36, 985-1048
- High Polymer Analysis Handbook. 1995, 609-611